# EUROPEAN PATENT SPECIFICATION

(11) **EP 3 736 553 B1**
(45) Date of publication and mention of the grant of the patent: **15.06.2022**
(21) Application number: 19210205.1
(22) Date of filing: 19.11.2019
(51) Int. Cl.: G01L 19/00, G01L 19/04

(54) **PRESSURE TRANSDUCER INCLUDING KOVAR INTEGRATED PACKAGES**
DRUCKWANDLER MIT KOVAR-INTEGRIERTEN PACKUNGEN
TRANSDUCTEUR DE PRESSION COMPRENANT DES EMBALLAGES KOVAR INTÉGRÉS

(30) Priority: 06.05.2019 US 201916403743
(43) Date of publication of application: 11.11.2020
(73) Proprietor: ROSEMOUNT AEROSPACE INC., Burnsville, MN 55306-4898 (US)
(72) Inventor: GOLDEN, Jim, Afton, Minnesota 55001 (US); POTASEK, David P., Lakeville, Minnesota 55044 (US); STUELKE, Robert, Minneapolis, Minnesota 55412 (US)
(74) Representative: Dehns

(56) References cited:
- US-A1- 2008 277 747
- US-A1- 2016 076 960

## Description

### BACKGROUND

Exemplary embodiments pertain to the art of pressure transducers and, in particular, pressure transducers including Kovar headers.

Transducers, such as sensor or actuators, are often used in harsh environments, such as high temperature and corrosive environments. For example, it may be desired to place a microphone or dynamic pressure sensor in or adjacent to the combustion zone of a turbine, aircraft engine or internal combustion engine to detect dynamic pressure changes inside the turbine or engine. The dynamic pressure data can then be analyzed to track the efficiency and performance of the turbine or engine. The dynamic pressure sensor may also be utilized to track the acoustic characteristics of the turbine or engine (i.e., noise output).

However, such a transducer must be able to withstand high operating temperatures and pressures, wide ranges of temperature and pressure, and the presence of combustion byproducts. When the transducer is a MEMS (microelectromechanical system) device, the MEMS transducer may be susceptible to damage due to its inherent materials of manufacture, thereby requiring additional protection.

The transducer is typically electrically connected to an external device, controller or the like. The associated connections must also therefore be protected from the harsh environment to ensure proper operation of the transducer.

Typical transducers that can survive in harsh environments are typically formed of a strong, rugged metal such stainless steel. In such devices, a MEMS pressure die can be mounted to a stainless steel port.

Such devices, however, can be subject to temperature dependent stresses. This can arise due to the MEMS or other semiconductor die has a different coefficient of thermal expansion from the packaging or port to which it is mounted. In such cases, a change in temperature can cause a stress/strain on the semiconductor die, and depending on the function of the die, this stress/strain can impair performance.

Pressure assemblies and methods of forming them are disclosed in US/2008/277747 and US/2016/076960.

### BRIEF DESCRIPTION

Disclosed is a method of forming a pressure sensor assembly as defined by claim 1.

According to any prior method, the header and the pressure port may both be formed of a controlled expansion alloy.

According to any prior method, the controlled expansion alloy can be Kovar or alloy 52.

According to any prior method, the header can be coated with gold over nickel and the pressure port can be coated with nickel and the transition portion is formed of stainless steel.

According to any prior method, the method can further include: providing an inlet port preform between the transition portion to a pressure port as part of forming the inlet channel.

According to any prior method, the high temperature brazing process can exceed a temperature of 750° C.

According to any prior method, joining the header and the sensor to the pressure port can include: providing a port attachment preform over the projection of the pressure port so that it rests on or is near a shoulder of the pressure port body; passing the projection of the pressure port through a pressure inlet port formed in the header; and providing a die attachment preform on a distal end of the projection of the pressure port.

According to any prior method, the header can joined to the pressure port and the sensor simultaneously.

According to any prior method, the soldering process can be performed at a temperature below a temperature of 400° C.

According to any prior embodiment, a first end of the transistor portion is connected the pressure port and the method further includes welding a second end of the transition portion to a manifold.

Also disclosed is a pressure sensor assembly as defined by claim 11.

### BRIEF DESCRIPTION OF THE DRAWINGS

The following descriptions should not be considered limiting in any way. With reference to the accompanying drawings, like elements are numbered alike:
FIG. 1 is a partial cut-away side view of a pressure transducer including a sensor assembly according to one embodiment;
FIG. 2 is a partial cross-sectional view of portion of the sensor assembly as it is being assembled;
FIG. 3 is a partial cross-sectional view of portion of the sensor assembly of FIG. 2 after a header and a sensor have been attached; and
FIG. 4 is an exploded view of the pressure transducer of FIG. 1.

### DETAILED DESCRIPTION

[deleted].

An inexpensive method to package a MEMS pressure sensor is to seal a MEMS die within a protective casing that includes a cover, such as a cap, joined to a header formed of a controlled expansion alloy.

This package can be integrated into a transducer by sealing the sensor to a pressure port (i.e., a tube in fluid communication with the fluid to be measures) that passes at least partially through a hole in the header and welding the sensor to a stainless steel pressure adapter or transducer base. The sealing of the sensor to the pressure port is typically accomplished by o-rings.

Herein disclosed is a sensor assembly and method of forming a transducer that includes the sensor assembly that may provide seals without utilizing o-rings. In one embodiment, the seals are metallurgic seals that are less prone to failure than o-rings. In additional or alternatively, the transducer and methods can allow for integration of a sensor package (header and MEMS pressure die) to any stainless steel base plate to form a transducer.

As will be more fully described below, the transducer is formed by a method that allows for direct assembly by welding of the sensor assembly to a stainless steel base plate. The transducer is formed by modifying the sequence of assembly. The pressure port and a stainless steel transition element are first assembled by high temperature brazing. Next, the pressure port is sealed to both the header and the MEMS die using a soldering operation. The pressure port and the header can both be formed of controlled expansion alloy. As will be seen below, the pressure port and the header can be coated with different metals in one embodiment.

A cover is then attached to the header by a projection welding process. The resultant sensor package can then be welded to a stainless steel pressure interface to form a transducer.

A detailed description of one or more embodiments of the disclosed apparatus and method are presented herein by way of exemplification and not limitation with reference to the Figures

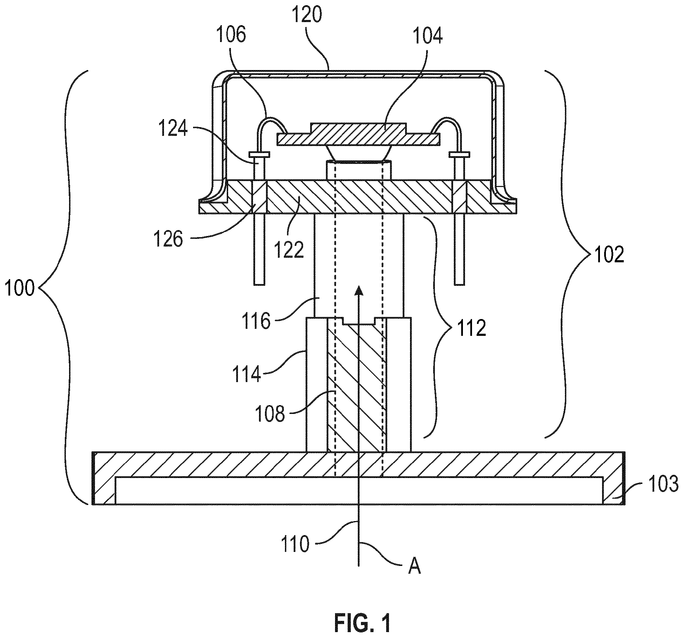

FIG. 1 shows a partial cross-sectional view of a pressure transducer 100 according to one embodiment. The pressure transducer 100 includes a sensor assembly 102 coupled to an interface 103. The interface 103 is formed of stainless steel in one embodiment. The interface 103 can be a stand-alone element or can be part of a larger assembly such as a manifold.

The sensor assembly 102 includes a pressure sensor 104. The pressure sensor 104 is a MEMS pressure sensor in one embodiment. While not show explicitly, the pressure sensor 104 can include a wafer stack and be in the form or a die and may be referred to herein as a die from time to time.

The sensor 104 can include one or more electrical connections such as wire bonds 106 that provide an output indicative of pressure in an inlet channel 108. In more detail, a fluid (liquid or gas) is resident in or passing through a sensing region 110. A portion of the fluid can travel from the sensing region 110 through the inlet channel 108 to directly or indirectly interact with the sensor 104 as indicated by arrow A. Such interaction can generate an electrical output on the electrical connections 106 that can then be read by a controller or other element to determine a pressure of the fluid in the sensing region 110.

The sensor 104 is encased in a protective housing formed of a cover 120 and header 122 that are joined together. In one embodiment, the cover 120 is joined to the header 122 by a projection weld. The cover 120 can be a stamp formed structure and, in one embodiment, is formed of nickel.

The header 122 includes one or more electrical pass-through elements 124 connected to the electrical connections 106. These elements are surrounded by a glass material 126 to allow them to pass through and not electrically contact the header 122. The glass material 126 may provide a seal between the electrical pass-through elements 124 and the header 122.

As discussed above, the header 122 can be formed of a controlled expansion alloy. One example of a controlled expansion alloy is ASTM F-15 ("Kovar"). Kovar is a nickel-cobalt ferrous alloy designed to have substantially the same thermal expansion characteristics as borosilicate glass(~5 × 10⁻⁶ /K between 30 and 200 °C, to ~10 × 10⁻⁶ /K at 800 °C) to allow a tight mechanical joint between the two materials over a range of temperatures. Other examples of a controlled expansion alloy include Alloy 52. By forming the header of a controlled expansion alloy the glass material 126 can be tightly joined to the header 118 to provide the aforementioned seal between them in manner that co-efficient of thermal expansion (CTE) differences between them do not lead to breaking of the glass material 126.

As illustrated, the sensor 104 is directly connected to an inlet port 112 that defines the inlet channel 108. The inlet port 112 includes a transition portion 114 and a pressure port 116. Both the transition portion 114 and the pressure port 116 can be hollow tubular members such as hollow cylinders and can be brazed together. The braze can be a high temperature braze utilizing a braze preform formed of a combination of gold and nickel, or other similar alloys. As used herein, a high temperature braze is brazing operation that occurs at or above 750° C.

The transition portion 114 is formed of stainless steel in one embodiment and the pressure port 116 is formed of a different material. In one embodiment, the pressure port 116 is formed of a controlled expansion alloy.

In one embodiment, the pressure port 116 and the header 122 are formed of the same of a controlled expansion alloy. In one embodiment, the pressure port 116 is formed of nickel (Ni) plated Kovar and the header 122 is formed of gold (Au) and nickel (Ni) plated Kovar. By having the pressure port 116 and the header 122 formed of the same material, possible damage to the header 122 can be reduced as both portions have the same or similar coefficients of thermal expansion.

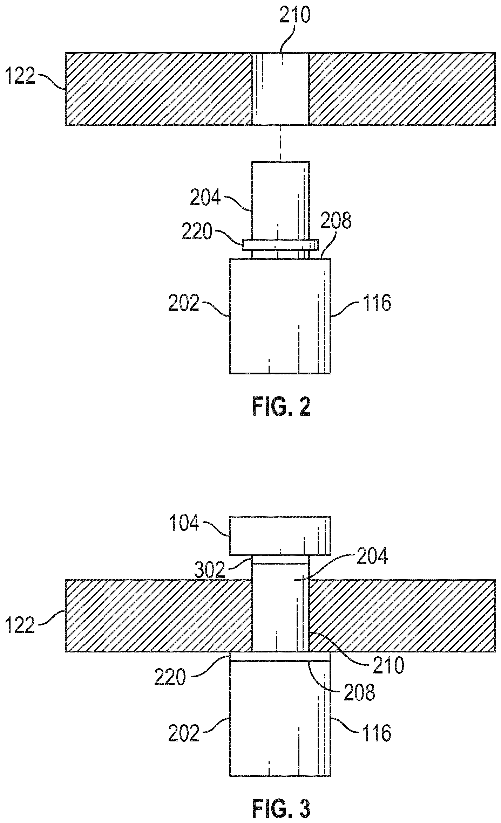

As best seen in FIG. 2, the header 122 is shown in cross section and includes a pressure inlet port 210 formed through it. The pressure port 116 passes at least partially through the pressure inlet port 210. As illustrated in FIG. 1, the pressure port 116 passes completely through the pressure inlet port 210 such that sensor 104 is separated from the header 122. In FIG. 2, the pressure port 116 is shown as having a base 202 and projection 204 extending from the base 202. The projection 204 has a smaller diameter that the base 202 in one embodiment. A shoulder 208 is defined on the base 202 due to the difference in diameters. As will be more fully described below, the shoulder 208 can carry a port attachment preform 220 that can be used to join and seal the header 122 to the pressure port 116. The port attachment preform 220 can be formed of a combination of gold and tin. Other materials and combinations thereof can also be used. For example, the port attachment preform 220 can be formed of gold and germanium. It will be understood that specific materials are given for the port attachment preform (and others) but all of them can be referred to as metal preforms.

In FIG. 3, the header 122 of FIG. 2 is shown with the projection 204 passing there through and with the sensor 104 attached to the projection 204. A die attachment preform 302 is shown disposed between the sensor 104 attached to a distal end of the projection 204. The die attachment preform 302 can be formed of the same or similar materials as the port attachment preform 220. In one embodiment, a structure including at least the elements shown in in FIG. 3 is formed and then a low temperature joining method such as a soldering process can be performed to join both the sensor 104 to the pressure port 116 (and in particular to the projection 204 thereof) and the pressure port 116 to the header 122. In one embodiment, the soldering process is performed at below 400° C. The low temperature nature of the soldering operation just described may protect the glass material 126 so that it is not broken during a high temperature braze. Thus, the high temperature braze discussed with respect to the joining the transition portion 114 and the pressure port 116 is performed before the soldering process in one embodiment.

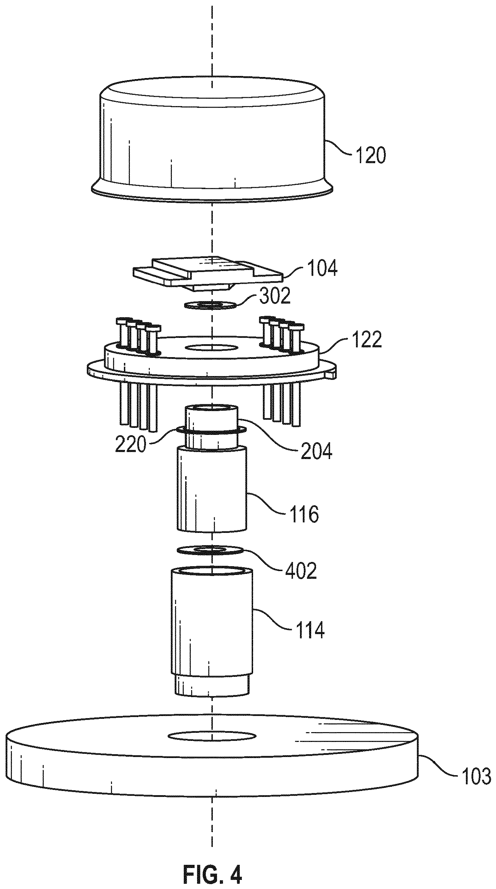

FIG. 4 shows an exploded view of the transducer 100 shown in FIG. 1. The transducer 100 shown in FIG. 4 includes, in addition to the elements shown in FIG. 1, particular identification of the an inlet port preform 402, the port attachment preform 220, and the die attachment preform 302. The following discussion of FIG. 4 will make reference to elements shown in FIGs. 1-3 and will be used to describe a method of forming a sensor assembly 102 that can be mated with an interface 103 to form a pressure transducer 100.

First, an inlet port 112 is formed. This inlet port 112 will define the inlet channel 108 in embodiment. This inlet port 112 is formed by joining the transition portion 114 to the pressure port 116 with a high temperature brazing processes. To that end, an inlet port preform 402 can be provided between the transition portion 114 and the pressure port 116. The inlet port preform 402 can be formed of a combination of gold and nickel. As above, the transition portion 114 is formed of stainless steel in one embodiment and the pressure port 116 is formed of a different material. In one embodiment, the pressure port 116 is formed of any controlled expansion alloy disclosed herein or an equivalent thereof. As will be appreciated, in one embodiment, the material forming the header 122 and the pressure port 116 may be same although they may be coated with different materials in one embodiment.

After the high temperature braze is completed, a low temperature process such as a soldering process is performed to join both the sensor 104 to the pressure port 116 (and in particular to the projection 204 thereof) and the pressure port 116 to the header 122. The soldering process can be done as a two-step process where the sensor 104 is joined to the pressure port 116 and the pressure port 116 is joined to the header 122 (or vice versa) or a single step process where the sensor 104 is joined to the pressure port 116 and the pressure port 116 is joined to the header 122 simultaneously.

In one embodiment, in order to perform soldering process, the port attachment preform 220 is provided on an end of the previously formed inlet port 112. In particular, the port attachment preform 220 is placed over the projection 204 of the pressure port 116 so that it rests on or is near the shoulder 208 of the pressure port base 202. Then, the header 122 is arranged on the pressure port projection 204 such that the pressure port projection 204 passes partly or completely through the pressure inlet port 210 formed in the header 118.

As discussed above, in one embodiment, the header 122 can be formed of the same material as the pressure port 116. For example, both can be formed of a controlled expansion alloy such as Kovar. In one embodiment, the header 122 is coated with gold (Au) over nickel (Ni) plating. The pressure port 116 can also be entirely coated with gold (Au) over nickel (Ni) plating but that is not required if the area for attachment is coated with gold (Au). In one embodiment, the pressure port 116 is formed of nickel (Ni) plated Kovar. As discussed above, a soldering process can be performed at this time to join the pressure port 116 to the header 122 is a two-step process is being utilized.

Regardless, a die attachment preform 302 can be provided at or near an end of the pressure port projection 204. As illustrated in FIG. 3, the die attachment preform 302 is provided at a distal end of the pressure port projection 204 but other locations are acceptable as longs as the sensor 104 can be effectively coupled to the pressure port projection 204. The die attachment preform 302 can be formed of the same material as the port attachment preform 220.

In the case involving a single soldering process, the sensor 104 is joined to the pressure port 116 and the pressure port 116 is joined to the header 122 simultaneously by applying heat so the port attachment preform 220 and the die attachment preform 302 melt or otherwise change state to bond adjacent elements.

In the case where a two-step process is performed, the heat could be applied just or primarily to the die attachment preform 302.

Regardless, after the soldering process is performed, the cover 120 can then be attached to the header 118 to form the sensor assembly 102. Attaching the cover 120 to the header 118 can include projection welding the cover 120 to the header 118. The cover 120 is a nickel stamp formed structure in one embodiment. Of course, the electrical connections 106 discussed above, can be provided before the header 118 and the cover 120 are attached to one another.

Lastly, to form a transducer such as transducer 100, the transition portion 114 is attached to the interface 103. In particular, above, a first end of the transition portion 114 was joined to the pressure port 116. Here, a second end of the transition portion 114 is joined to the interface 103. In one embodiment, both the transition portion 114 and the interface 103 are formed of the same material. For example, both the transition portion 114 and the interface 103 are formed of stainless steel in one embodiment. The transition portion 114 can be welded to the interface 103 in one embodiment. In particular, the transition portion 114 can be welded to the interface 103 by either a laser or tungsten inert gas (TIG) welding processes.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the invention as defined by the claims. In addition, many modifications may be made to adapt a particular situation or material to the teachings of the present disclosure without departing from the scope of the invention. Therefore, it is intended that the present disclosure not be limited to the particular embodiment disclosed as the best mode contemplated for carrying out this present disclosure, but that the present disclosure will include all embodiments falling within the scope of the claims.

## Claims

1. A method of forming a pressure sensor assembly, the method comprising:
forming an inlet channel (108) by brazing a transition portion (114) to a pressure port (116) with a high temperature brazing process; **characterised in that** the transition portion and the pressure port are both hollow tubular members and are formed of different materials, the pressure port including a base (202) and a projection (204) extending therefrom;
the method further **characterised in that** after the inlet channel is formed, joining a header (122) and a sensor (104) to the pressure port with a soldering process that is at a lower temperature than the high temperature brazing process, wherein the header is joined to the base of the pressure port and the sensor is joined to the projection of the pressure port and is in fluid communication with a fluid to be measured through the pressure port; and
welding a cover (120) to the header (122).

2. The method of claim 1, wherein the header and the pressure port are both formed of a controlled expansion alloy.

3. The method of claim 2, wherein the controlled expansion alloy is Kovar or alloy 52.

4. The method of claim 2 or 3, wherein the header is coated with gold over nickel and the pressure port is coated with nickel and the transition portion is formed of stainless steel.

5. The method of any preceding claim, further comprising:
providing an inlet port preform between the transition portion to a pressure port as part of forming the inlet channel.

6. The method of claim 5, wherein the high temperature brazing process exceeds a temperature of 750° C.

7. The method of any preceding claim, wherein joining the header and the sensor to the pressure port includes:
providing a port attachment preform (220) over the projection of the pressure port so that it rests on or is near a shoulder of the pressure port body;
passing the projection of the pressure port through a pressure inlet port formed in the header; and
providing a die attachment preform (302) on a distal end of the projection of the pressure port.

8. The method of claim 7, wherein the header is joined to the pressure port and the sensor simultaneously.

9. The method of claim 7 or 8, wherein the soldering process is performed at a temperature below a temperature of 400° C.

10. The method of any preceding claim, for a pressure transducer ,comprising:
forming the inlet channel by brazing a first end of the transition portion to the pressure port with the high temperature brazing process; and further comprising
welding the second end of the transition portion to a manifold.

11. A pressure sensor assembly comprising:
an inlet channel (108) including a transition portion (114) to a pressure port (116), the assembly **characterised in that** the transition portion and the pressure port are joined by a metal inlet port preform, wherein the transition portion and the pressure port are both hollow tubular members and are formed of different materials, the pressure port including a base (202) and a projection (204) extending therefrom;
the assembly further **characterised in that** it includes:
a header (122) joined to a shoulder (208) on the base of the pressure port by a metal port attachment preform (220);
a sensor (104) joined to a distal end of the projection of the pressure port by a metal die attachment preform (302); and
a cover (120) connected to the header.

12. The sensor assembly of claim 11, wherein the header and the pressure are both formed of a controlled expansion alloy.

13. The sensor assembly of claim 11 or 12, wherein the controlled expansion alloy is Kovar or alloy 52 and the transition portion is formed of stainless steel.

14. The sensor assembly of claim 13, wherein the header is coated with gold over nickel and the pressure port is coated with nickel.

## Patentansprüche

1. Verfahren zum Bilden einer Drucksensoranordnung, wobei das Verfahren Folgendes umfasst:
Bilden eines Einlasskanals (108) durch Hartlöten eines Übergangsabschnitts (114) an eine Drucköffnung (116) mit einem Hochtemperatur-Hartlötprozess; **dadurch gekennzeichnet, dass** der Übergangsabschnitt und die Drucköffnung beide hohle röhrenförmige Elemente sind und aus unterschiedlichen Materialien gebildet sind, wobei die Drucköffnung eine Basis (202) und einen Vorsprung (204), der sich davon erstreckt, beinhaltet;
wobei das Verfahren weiter **dadurch gekennzeichnet ist, dass** nach dem Bilden des Einlasskanals ein Kopfteil (122) und ein Sensor (104) mit der Drucköffnung mit einem Lötprozess verbunden werden, der eine niedrigere Temperatur als der Hochtemperatur-Hartlötprozess aufweist, wobei das Kopfteil mit der Basis der Drucköffnung verbunden ist und der Sensor mit dem Vorsprung der Drucköffnung verbunden ist und mit einem Fluid, das gemessen werden soll, durch die Drucköffnung in Fluidverbindung steht; und
Schweißen einer Abdeckung (120) an das Kopfteil (122).

2. Verfahren nach Anspruch 1, wobei das Kopfteil und die Drucköffnung beide aus einer Legierung mit gesteuerter Dehnung gebildet sind.

3. Verfahren nach Anspruch 2, wobei die Legierung mit gesteuerter Dehnung Kovar oder Alloy 52 ist.

4. Verfahren nach Anspruch 2 oder 3, wobei das Kopfteil mit Gold über Nickel beschichtet ist und die Drucköffnung mit Nickel beschichtet ist und der Übergangsabschnitt aus rostfreiem Stahl gebildet ist.

5. Verfahren nach einem vorstehenden Anspruch, das weiter Folgendes umfasst:
Bereitstellen einer Einlassöffnungsvorform zwischen dem Übergangsabschnitt zu einer Drucköffnung als Teil des Bildens des Einlasskanals.

6. Verfahren nach Anspruch 5, wobei der Hochtemperatur-Hartlötprozess eine Temperatur von 750°C überschreitet.

7. Verfahren nach einem vorstehenden Anspruch, wobei das Verbinden des Kopfteils und des Sensors mit der Drucköffnung Folgendes beinhaltet:
Bereitstellen einer Öffnungsbefestigungsvorform (220) über dem Vorsprung der Drucköffnung derart, dass sie auf einer Schulter des Drucköffnungskörpers ruht oder sich in der Nähe einer Schulter befindet;
Durchführen des Vorsprungs der Drucköffnung durch eine Druckeinlassöffnung, die in dem Kopfteil gebildet ist; und
Bereitstellen einer Gesenkbefestigungsvorform (302) auf einem distalen Ende des Vorsprungs der Drucköffnung.

8. Verfahren nach Anspruch 7, wobei das Kopfteil mit dem Drucköffnung und dem Sensor gleichzeitig verbunden wird.

9. Verfahren nach Anspruch 7 oder 8, wobei der Lötprozess bei einer Temperatur unterhalb einer Temperatur von 400°C ausgeführt wird.

10. Verfahren nach einem vorstehenden Anspruch für einen Druckwandler, das weiter Folgendes umfasst:
Bilden des Einlasskanals durch Hartlöten eines ersten Endes des Übergangsabschnitts an die Drucköffnung mit dem Hochtemperatur-Hartlötprozess; und das weiter
Schweißen des zweiten Endes des Übergangsabschnitts an einen Verteiler umfasst.

11. Drucksensoranordnung, die Folgendes umfasst:
einen Einlasskanal (108), der einen Übergangsabschnitt (114) zu einer Drucköffnung (116) beinhaltet, wobei die Anordnung **dadurch gekennzeichnet ist, dass** der Übergangsabschnitt und die Drucköffnung durch eine Einlassöffnungsvorform aus Metall verbunden sind, wobei der Übergangsabschnitt und die Drucköffnung beide hohle röhrenförmige Elemente sind und aus unterschiedlichen Materialien gebildet sind, wobei die Drucköffnung eine Basis (202) und einen Vorsprung (204), der sich davon erstreckt, beinhaltet;
wobei die Anordnung weiter **dadurch gekennzeichnet ist, dass** sie beinhaltet:
ein Kopfteil (122), das mit einer Schulter (208) auf der Basis der Drucköffnung durch eine Öffnungsbefestigungsvorform (220) aus Metall verbunden ist;
einen Sensor (104), der mit einem distalen Ende des Vorsprungs der Drucköffnung durch eine Gesenkbefestigungsvorform (302) aus Metall verbunden ist; und
eine Abdeckung (120), die mit dem Kopfteil verbunden ist.

12. Sensoranordnung nach Anspruch 11, wobei das Kopfteil und der Druck beide aus einer Legierung mit gesteuerter Dehnung gebildet sind.

13. Sensoranordnung nach Anspruch 11 oder 12, wobei die Legierung mit gesteuerter Dehnung Kovar oder Alloy 52 ist, und der Übergangsabschnitt aus rostfreiem Stahl gebildet ist.

14. Sensoranordnung nach Anspruch 13, wobei der Sockel mit Gold über Nickel beschichtet ist und die Drucköffnung mit Nickel beschichtet ist.

## Revendications

1. Procédé de formation d'un ensemble capteur de pression, le procédé comprenant :
la formation d'un canal d'entrée (108) en brasant une partie de transition (114) à un orifice de pression (116) avec un procédé de brasage à haute température ; **caractérisé en ce que** la partie de transition et l'orifice de pression sont tous deux des éléments tubulaires creux et sont formés de matériaux différents, l'orifice de pression comportant une base (202) et une saillie (204) s'étendant depuis celle-ci ;
le procédé étant en outre **caractérisé par**, après la formation du canal d'entrée, la liaison d'un collecteur (122) et d'un capteur (104) à l'orifice de pression avec un procédé de soudage qui est à une température inférieure à celle du procédé de brasage à haute température, dans lequel le collecteur est relié à la base de l'orifice de pression et le capteur est relié à la saillie de l'orifice de pression et est en communication fluidique avec un fluide à mesurer à travers l'orifice de pression ; et
le soudage d'un couvercle (120) au collecteur (122).

2. Procédé selon la revendication 1, dans lequel le collecteur et l'orifice de pression sont tous deux formés d'un alliage à dilatation contrôlée.

3. Procédé selon la revendication 2, dans lequel l'alliage à dilatation contrôlée est le Kovar ou l'alliage 52.

4. Procédé selon la revendication 2 ou 3, dans lequel le collecteur est revêtu d'or sur du nickel et l'orifice de pression est revêtu de nickel et la partie de transition est formée d'acier inoxydable.

5. Procédé selon une quelconque revendication précédente, comprenant en outre :
la fourniture d'une préforme d'orifice d'entrée entre la partie de transition et un orifice de pression dans le cadre de la formation du canal d'entrée.

6. Procédé selon la revendication 5, dans lequel le procédé de brasage à haute température dépasse une température de 750 °C.

7. Procédé selon une quelconque revendication précédente, dans lequel la liaison du collecteur et du capteur à l'orifice de pression comporte :
la fourniture d'une préforme de fixation d'orifice (220) sur la saillie de l'orifice de pression de sorte qu'il repose sur un épaulement du corps d'orifice de pression ou qu'il soit proche de celui-ci ;
le passage de la saillie de l'orifice de pression à travers un orifice d'entrée de pression formé dans le collecteur ; et
la fourniture d'une préforme de fixation de matrice (302) sur une extrémité distale de la saillie de l'orifice de pression.

8. Procédé selon la revendication 7, dans lequel le collecteur est relié simultanément à l'orifice de pression et au capteur.

9. Procédé selon la revendication 7 ou 8, dans lequel le procédé de soudage est effectué à une température inférieure à une température de 400 °C.

10. Procédé selon une quelconque revendication précédente, pour un transducteur de pression, comprenant :
la formation du canal d'entrée en brasant une première extrémité de la partie de transition à l'orifice de pression avec le procédé de brasage à haute température ; et comprenant en outre le soudage de la seconde extrémité de la partie de transition à un collecteur.

11. Ensemble capteur de pression comprenant :
un canal d'entrée (108) comportant une partie de transition (114) vers un orifice de pression (116), l'ensemble étant **caractérisé en ce que** la partie de transition et l'orifice de pression sont reliés par une préforme d'orifice d'entrée métallique, dans lequel la partie de transition et l'orifice de pression sont tous deux des éléments tubulaires creux et sont formés de matériaux différents, l'orifice de pression comportant une base (202) et une saillie (204) s'étendant depuis celle-ci ; l'ensemble étant en outre **caractérisé en ce qu'**il comporte :
un collecteur (122) relié à un épaulement (208) sur la base de l'orifice de pression par une préforme de fixation d'orifice métallique (220) ;
un capteur (104) relié à une extrémité distale de la saillie de l'orifice de pression par une préforme de fixation de matrice métallique (302) ; et
un couvercle (120) relié au collecteur.

12. Ensemble capteur selon la revendication 11, dans lequel le collecteur et la pression sont tous deux formés d'un alliage à dilatation contrôlée.

13. Ensemble capteur selon la revendication 11 ou 12, dans lequel l'alliage à dilatation contrôlée est le Kovar ou l'alliage 52 et la partie de transition est formée d'acier inoxydable.

14. Ensemble capteur selon la revendication 13, dans lequel le collecteur est revêtu d'or sur du nickel et l'orifice de pression est revêtu de nickel.
